Europäisches Patentamt

(19) European Patent Office

Office européen des brevets

(11) Veröffentlichungsnummer: **0 163 128**
**A2**

# (12) EUROPÄISCHE PATENTANMELDUNG

(21) Anmeldenummer: 85105015.3

(22) Anmeldetag: 25.04.85

(51) Int. Cl.⁴: **G 03 F 7/20**
G 03 F 7/26, G 03 F 7/10

(30) Priorität: 21.05.84 DE 3418854

(43) Veröffentlichungstag der Anmeldung:
04.12.85 Patentblatt 85/49

(84) Benannte Vertragsstaaten:
CH DE FR GB LI NL

(71) Anmelder: ERNST LEITZ WETZLAR GMBH
Ernst-Leitz-Strasse 30 Postfach 20 20
D-6330 Wetzlar 1(DE)

(72) Erfinder: Heitmann, Knut, Dipl.-Ing.
Lerchenweg 16
D-6330 Wetzlar(DE)

(72) Erfinder: Hoppe, Martin, Dr. Dipl.-Ing.
Helgebachstrasse 29
D-6330 Wetzlar(DE)

(72) Erfinder: Schneider, Eckart
Lauerstrasse 3
D-6330 Wetzlar(DE)

(72) Erfinder: Thaer, Andreas, Dr. rer. nat.
Steinweg 8
D-6301 Leihgestern(DE)

(54) Verfahren zur Erzeugung von Strukturen in Resistschichten.

(57) Ein Verfahren zur Erzeugung von Strukturen durch Polymerisation bzw. Depolymerisation von Resistschichten besteht darin, daß eine unvollständige Belichtung der Resistschicht entsprechend dem Muster der Strukturen erfolgt und durch Einstrahlung von Ultraschall die Struktur in der Resistschicht voll ausgebildet wird.

Für die Beschallung wird vorzugsweise ein akustisches Mikroskop verwendet, mit dem dite Strukturbildung in der Resistschicht auch beobachtet werden kann.

EP 0 163 128 A2

Verfahren zur Erzeugung von Strukturen
in Resistschichten

Die Erfindung betrifft ein Verfahren zur Erzeugung von
Strukturen durch Polymerisation bzw. Depolymerisation
von Resistschichten.

Unter einem Resist soll hier eine Masse verstanden werden, die auf einer Substratoberfläche aufgebracht werden kann, um den von ihr bedeckten Teil zu maskieren,
d.h. dem Angriff von z.B. Ätzmitteln, chemischen oder
galvanischen Metallisierungsbädern usw. zu entziehen.
Resiste, wie z.B. Fotolacke, haben die Eigenschaft, daß
sich ihre Löslichkeit durch Belichtung mit UV-, Elektronen-, Röntgen- oder Ionenstrahlen ändert. Dabei
kommt es entweder zur Bildung von Polymeren und deren
Vernetzung (sog. Negativschicht) oder zum Aufbrechen
von Polymeren und Überführen in niedermolekulare lösliche Verbindungen (sog. Positivschicht). Die Eigenschaft der Löslichkeitsänderung in den bestrahlten bzw.
nicht bestrahlten Flächenbereichen wird ausgenutzt, um durch nachfolgende chemische Entwicklungsprozesse ein Auswaschrelief auf der Substratoberfläche zu erzeugen.

Die fortschreitende Integrationsdichte bei integrierten Schaltungen verlangt immer höhere Auflösung und geringere Dimensionstoleranzenbei zunehmender Feldgröße des Strukturbildes. Um diesen Forderungen gerecht zu werden, wurden zusätzlich zum Standardverfahren der Lithographie, der UV-Belichtung, neue lithographische Verfahren mit Elektronenstrahlen, Röntgenstrahlen und Ionenstrahlen entwickelt. Die mit diesen neuen Verfahren ermöglichten geringeren Strukturbreiten in den Resistschichten werden jedoch durch einige z.T. gravierende Nachteile erkauft.

So hat z.B. die Elektronenstrahlbelichtung mit einem direkt die Strukturen schreibenden Strahl den Vorteil hoher Auflösung und geringerer Feldverzerrungen, ist jedoch aufgrund der sehr langen Belichtungszeiten meistens noch unwirtschaftlich. Während bei UV-Belichtung ein 4''-Wafer innerhalb einiger Sekunden belichtet werden kann, benötigt die Elektronenstrahlbelichtung meist mehrere 10 Minuten. Durch Projektion einer Maske mit Elektronenstrahlen kommt man zwar zu kürzeren Belichtungszeiten von etwa 2 - 3 Minuten, erreicht dann jedoch keine Höchstauflösung und hat den Nachteil der erforderlichen speziellen aufwendigen Elektronenstrahlmasken.

Auch die Röntgenlithographie erfordert meist lange Belichtungszeiten von bis zu 15 Minuten pro 4''-Wafer.

Zudem sind hier nur Proximity-Projektionstechniken möglich, die extreme Anforderungen an die zu verwendenden 1:1-Masken stellen.

Der Erfindung lag daher die Aufgabe zugrunde, ein Verfahren anzugeben, mit dem sich die Belichtungszeiten der hochauflösenden lithographischen Verfahren bei Resistschichten, insbesondere Lackschichten, wesentlich reduzieren lassen.

Diese Aufgabe wird bei einem Verfahren der eingangs genannten Art erfindungsgemäß durch die kennzeichnenden Merkmale des Anspruchs 1 gelöst. Vorteilhafte Ausgestaltungen des Verfahrens ergeben sich aus den Ansprüchen 2 bis 9.

Der Erfindung liegt die Beobachtung zugrunde, daß der Zeitfaktor bei den bekannten lithographischen Verfahren wesentlich durch den die Lackschicht durchdringenden Polymerisations- bzw. Depolymerisationsvorgang bestimmt wird. In überraschender Weise wurde gefunden, daß bereits eine "Anbelichtung" der Lackschicht ausreicht, um die gewünschte Struktur in ihr festzulegen und daß durch eine z.B. nachfolgende Einstrahlung von Ultraschall die "Durchbelichtung" der Lackschicht ohne Verringerung der ursprünglichen Auflösung bewerkstelligt werden kann. Mit Hilfe der bekannten lithographischen Verfahren brauchen also lediglich die gewünschten Strukturen in der Lackschicht initiert zu werden. Das führt zu einer erheblichen Verringerung der Prozeßzeiten für diese Apparaturen. Die zeitaufwendige Vernetzung bzw. Fragmentierung durch die gesamte Lackschichtdicke hindurch bis auf die Substratschicht wird auf die wesentlich leichter handhabbare Bestrahlung mit Ultraschall verlegt. Diese könnte z.B. integral über die gesamte zu belichtende Fläche hinweg erfolgen und bereits während des lithographischen Prozesses einsetzen und auch von der Rückseite der Lackschicht her einwirken.

Besondere Vorteile ergeben sich jedoch, wenn ein fein gebündelter Ultraschallstrahl verwendet wird, der die Lackschicht rasterförmig abtastet. Zur Schallbündelung kann ein an sich bekanntes akustisches Linsensystem genommen werden, mit dem auch ein linienförmig fokussiertes Ultraschallstrahlenbündel erzeugt werden kann.

Da die lithographische unvollständige Belichtung und die Beschallung mit Ultraschall physikalisch voneinander unabhängig sind, können beide Verfahrensschritte zweckmäßigerweise zeitlich nacheinander und auch in unterschiedlichen Apparaturen durchgeführt werden. Besonders vorteilhaft für die Durchführung des zweiten Verfahrensschrittes ist ein akustisches Mikroskop. Mit diesem kann auch die jeweils erreichte Vernetzung bzw. Fragmentierung sichtbar dargestellt werden, und zwar bevor die Resistschicht chemisch entwickelt wird. Damit können auch Fehler in der Struktur erkannt und durch selektive, lokale intensivere Beschallung weitgehend korrigiert werden. Das Ende der Beschallung kann in Abhängigkeit von dem dargestellten Bild bestimmt werden.

Durch Beobachtung der Vernetzungs- und Fragmentierungsfortschritte in der Resistschicht mit Hilfe eines akustischen Mikroskops können auch die günstigsten Ultraschallfrequenzen und Intensitäten für die Beschallung
in Abhängigkeit von der Linienbreite, der Strukturelemente der Schichtdicke und dem speziellen Material des
Resists bestimmt werden.

Die Ankopplung der Ultraschallstrahlen von der akustischen Linsenanordnung zur Resistfläche geschieht in
bekannter Weise mit Hilfe eines zwischengeschalteten
Immersionsmittels, wie z.B. Wasser.

0163128

Ansprüche

1. Verfahren zur Erzeugung von Strukturen durch Polymerisation bzw. Depolymerisation von Resistschichten d a d u r c h   g e k e n n z e i c h n e t , daß eine unvollständige Belichtung der Resistschicht entsprechend dem Muster der Struktur erfolgt und durch Einstrahlung von Ultraschall die Struktur in der Resistschicht voll ausgebildet wird.

2. Verfahren nach Anspruch 1,   d a d u r c h   g e - k e n n z e i c h n e t ,   daß die gesamte Resistschicht integral beschallt wird.

3. Verfahren nach einem der Ansprüche 1 oder 2, d a d u r c h   g e k e n n z e i c h n e t ,   daß die unvollständige Belichtung und die Beschallung gleichzeitig von gegenüberliegenden Seiten der Resistschicht erfolgen.

4. Verfahren nach Anspruch 1, d a d u r c h  g e - k e n n z e i c h n e t ,  daß die Resistschicht mit einem fein gebündelten Ultraschallstrahl in einer rasterförmigen Abtastung beschallt wird.

5. Verfahren nach einem der Ansprüche 1, 2 oder 4, d a d u r c h  g e k e n n z e i c h n e t ,  daß unvollständige Belichtung und Beschallung nacheinander erfolgen.

6. Verfahren nach einem der vorhergehenden Ansprüche, d a d u r c h  g.e k e n n z e i c h n e t ,  daß zur Beschallung ein akustisches Mikroskop verwendet wird.

7. Verfahren nach Anspruch 6, d a d u r c h  g e - k e n n z e i c h n e t ,  daß die Strukturbildung in der Resistschicht durch das akustische Mikroskop bildlich dargestellt und das Ende der Beschallung in Abhängigkeit von dem dargestellten Bild bestimmt wird.

8. Verfahren nach Anspruch 7, d a d u r c h  g e - k e n n z e i c h n e t ,  daß eine selektive Beschallung einzelner Strukturelemente erfolgt.

9. Verfahren nach einem der vorhergehenden Ansprüche, d a d u r c h  g e k e n n z e i c h n e t ,  daß die Schallfrequenz und die Intensität der Beschallung in Abhängigkeit von der Linienbreite der Strukturelemente und der Schichtdicke der Resistschicht bestimmt werden.